# EUROPÄISCHE PATENTSCHRIFT

(11) **EP 0 766 399 B1**
(45) Veröffentlichungstag und Bekanntmachung des Hinweises auf die Patenterteilung: **29.11.2000**
(21) Anmeldenummer: 96114028.2
(22) Anmeldetag: 02.09.1996
(51) Int. Cl.: H03K 19/003

(54) **Bidirektionale Treiberschaltung für PCI-Bussysteme**
Bidirectional driver circuit for PCI bussystem
Circuit d'attaque bidirectionnel pour système de bus PCI

(30) Priorität: 27.09.1995 DE 19536020
(43) Veröffentlichungstag der Anmeldung: 02.04.1997
(73) Patentinhaber: SIEMENS AKTIENGESELLSCHAFT, 80333 München (DE)
(72) Erfinder: Nebel, Gerhard, 87509 Immenstadt (DE); Frechet, Vincent, 78430 Louveciennes (FR); Schmitt-Landsiedel, Doris, Dr., 85521 Ottobrunn (DE)

(56) Entgegenhaltungen:
- US-A- 5 418 476
- PATENT ABSTRACTS OF JAPAN vol. 013, no. 026 (E-706), 20.Januar 1989 & JP 63 228661 A (HITACHI LTD), 22.September 1988,
- PATENT ABSTRACTS OF JAPAN vol. 095, no. 006, 31.Juli 1995 & JP 07 086910 A (OKI ELECTRIC IND CO LTD), 31.März 1995,
- PATENT ABSTRACTS OF JAPAN vol. 095, no. 006, 31.Juli 1995 & JP 07 086904 A (KAWASAKI STEEL CORP), 31.März 1995,

## Beschreibung

Bei modernen CMOS-Prozessen sind heute minimale Kanallängen und Gateoxiddicken möglich, die der früher üblichen Betriebsspannung digitaler Schaltung von 5 V nicht mehr standhalten. Deshalb hat sich eine reduzierte Betriebsspannung von 3,3 V für digitale Schaltungen durchgesetzt. Da aber aus Gründen der Kompatibilität keine abrupte Umstellung möglich ist, sind in der Übergangszeit Schaltungen erforderlich, die mit beiden Betriebsspannungen arbeiten können bzw. die unterschiedliche Signalpegel für denselben logischen Wert richtig verarbeiten können. Der PCI-Bus berücksichtigt diese beiden Betriebsspannungswerte und definiert Schaltpegel, Lastkapazitäten, Zeitverhältnisse usw. sowohl für 5 V als auch für 3,3 V Signalspannungen. Die Steckverbindungen auf einem Motherboard stellen beide Betriebsspannungen zur Verfügung, sowie eine Markierung, die den auf dem Motherboard verwendeten Signalpegel festlegt. Dieser Signalpegel legt jedoch lediglich fest, mit welchen Spannungswerten die Daten auf dem Bus ausgetauscht werden und betrifft nicht die jeweilige Betriebsspannung der einzelnen Schaltungen auf den verschiedenen Steckkarten.

Aus der Veröffentlichung von Y. Nakagome et al., "Circuit Techniques for 1.5-3.6-V Battery-Operated 64-Mb DRAM", IEEE J. of Solid-State Circuits, Vol. 26, No. 7, pp. 1003-1010, July 1991 wird beispielsweise eine Schaltung unter dem Begriff "5 V/3,3 V Pegelumsetzer" vorgestellt, die den Einsatz einer 3,3 V Technologie für 5 V Ein- und Ausgangssignale ermöglicht. Der PCI-Bus arbeitet bei der 5 V Signalumgebung mit TTL-Pegeln, bei denen für eine logische Eins am Ausgang lediglich 2,4 V gefordert sind. Dadurch ist es möglich, die Schaltung nur mit 3,3 V zu betreiben, weil für den Pegel einer logischen Eins keine 5 V erforderlich sind. Da aber andere Busteilnehmer 5 V für den Pegel einer logischen Eins liefern können und dabei nicht kurzgeschlossen werden dürfen, kann die Spannung auf dem Bus nicht auf 3,3 V begrenzt werden. Bei Y. Nakagome et al. ist insbesondere aus Figur 4 der vergleichsweise hohe Aufwand einer "echten 5V-Signal-Schaltung" ersichtlich, da diese Schaltung jeweils, wegen der 5 Volt, zwei Strompfade mit je vier in Reihe geschalteten Transistoren aufweist, die darüber hinaus ein relativ langsames Schaltverhalten bewirken.

Die der Erfindung zugrundeliegende Aufgabe liegt nun darin, eine bidirektionale Treiberschaltung für PCI-Bussysteme anzugeben, bei der im hochohmigen Zustand (Tristate) externe Signalspannungen bis zu 5 V möglich sind und dabei gleichzeitig verhindert wird, daß hierbei ein Strom in die Treiberschaltung hineinfließt und bei der dies mit möglichst geringem Aufwand, beispielsweise ohne die sehr aufwendigen Vorkehrungen zur Erzeugung echter 5 V Signale, erfolgt.

Diese Aufgabe wird erfindungsgemäß durch die Merkmale des Patentanspruchs 1 gelöst. Die abhängigen Ansprüche betreffen vorteilhafte Ausgestaltungen der erfindungsgemäßen Treiberschaltung.

Die Erfindung ist nachfolgend anhand der Zeichnungen näher erläutert. Dabei zeigt
- Figur 1: eine erfindungsgemäße Treiberschaltung mit einer im Blockschaltbild dargestellten Ansteuerlogik und
- Figur 2: ein Schaltbild für die Ansteuerlogik von Figur 1.

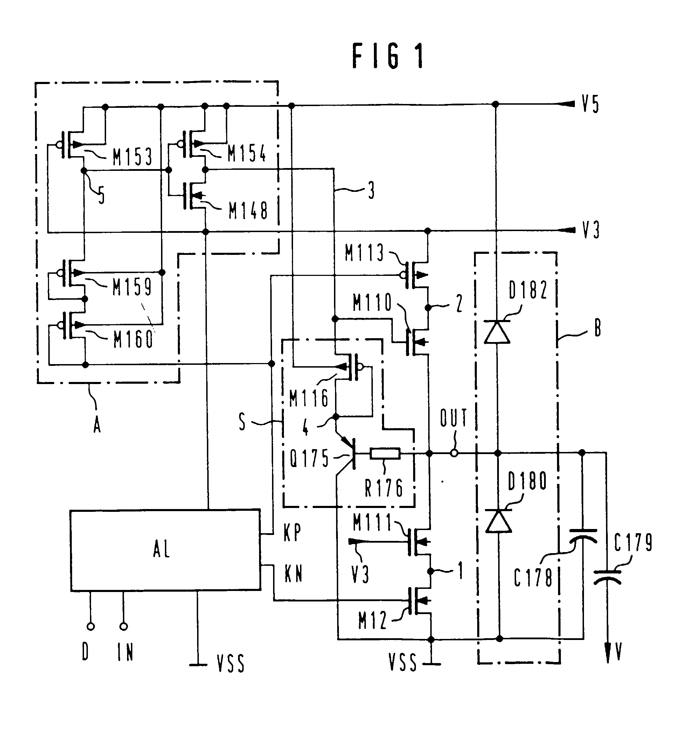

Figur 1 zeigt eine erfindungsgemäße Treiberschaltung mit einer als Blockschaltbild dargestellten Ansteuerlogik AL, einer Ansteuerschaltung A, einer Schutzschaltung S, einer Begrenzerschaltung B sowie vier in Reihe geschaltete MOS-Feldeffekttransistoren M110 ... M113, wobei es sich bei den Transistoren M110, M111 und M112 um n-Kanal-MOS-Transistoren und beim Transistor M113 um einen p-Kanal-Transistor handelt. Zumindest der MOS-Feldeffekttransistor M110 ist vom Anreicherungstyp (enhancement n-channel MOS-transistor).
Ein erster Anschluß des Transistors M112 ist mit Bezugspotential VSS und ein zweiter Anschluß über einen Knoten 1 mit einem ersten Anschluß des Transistors M111 verbunden, dessen zweiter Anschluß über einen Ausgangsknoten OUT des Treibers mit einem ersten Anschluß des Transistors M110 verbunden ist. Ein zweiter Anschluß des Transistors M110 ist über einen Knoten 2 mit einem ersten Anschluß des Transistors M113 verbunden, dessen zweiter Anschluß mit der 3,3 V Versorgungsspannung V3 verbunden ist.

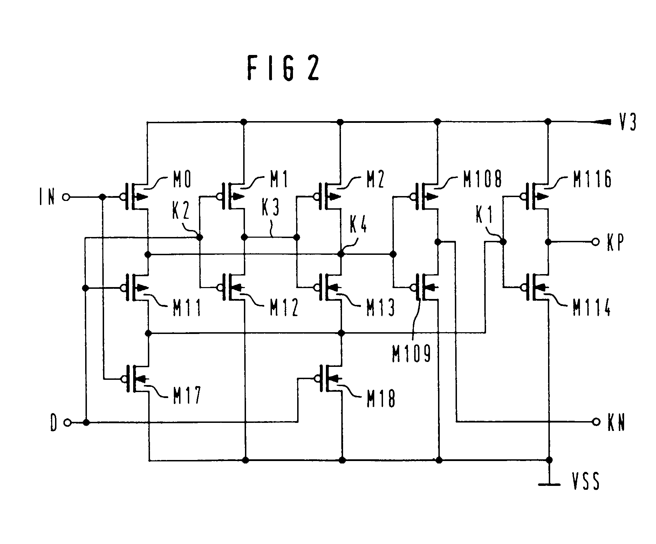

Die Ansteuerlogik AL ist mit Bezugspotential VSS verbunden und wird mit 3,3 V versorgt. Die Ansteuerlogik AL weist einen Signaleingang IN und einen Sperreingang D (Disable) auf und erzeugt zwei Ausgangssignale KP und KN. Die Signale KP und KN sind dabei im "pull-up-Zustand" jeweils Null, im "Pull-down-Zustand" jeweils Eins und im "Tristate-Zustand" zueinander invers, wobei KP=1 und KN= 0 sind. Ein beispielhafter Aufbau der Ansteuerlogik wird nachfolgend im Zusammenhang mit Figur 2 beschrieben.

Die Ansteuerschaltung A weist vier p-Kanal-MOS-Transistoren M153, M154, M159 und M160 sowie einen n-Kanal-MOS-Transistor M148 auf, wobei alle Substratanschlüsse der p-Kanal-MOS-Transistoren über eine Leitung V5 mit 5 V versorgt sind. Ein erster Anschluß des Transistors M153 ist mit der Leitung V5 verbunden und der zweite Anschluß des Transistors M153 ist über einen Verbindungsknoten 5 mit einem ersten Anschluß des Transistors M159 verbunden, dessen zweiter Anschluß mit dem Gate des Transistors M159 und einem ersten Anschluß des Transistors M160 verbunden ist. Ein zweiter Anschluß des Transistors M160 ist mit dem Gate des Transistors M160 verbunden und mit dem Ausgangssignal KP der Ansteuerlogik AL beschaltet. Der Gateanschluß des Transistors M153 ist mit der Leitung V3, also mit 3,3 V, verbunden. Der Knoten 5 ist mit den Gateanschlüssen der in Reihe geschalteten Transistoren M154 und M148 verbunden. Ein erster Anschluß des Transistors M154 ist mit der Leitung V5 und ein zweiter Anschluß des Transistors M154 ist über einen Knoten 3 mit einem ersten Anschluß des Transistors M148 verbunden, dessen zweiter Anschluß mit der Leitung V3 verbunden ist und wobei der Knoten 3 gleichzeitig den Ausgang der Ansteuerschaltung A darstellt. Das Gate des Transistors M110 ist mit dem Knoten 3 verbunden und das Gate des Transistors M111 liegt auf 3,3 V. Das Gate des Transistors M113 ist mit dem Signal KP und das Gate des Transistors M112 mit dem Signal KN beschaltet.

Die Schutzschaltung S weist einen p-Kanal-MOS-Transistor M166 auf, dessen erster Anschluß mit dem Knoten 3 und dessen zweiter Anschluß und Gateanschluß über einen Knoten 4 mit einem Emitteranschluß eines Bipolartransistors Q175 verbunden ist. Die Basis des Bipolartransistors Q175 ist dabei über einen Widerstand R176 mit dem Ausgang OUT und der Kollektoranschluß dieses Transistors ist mit Bezugspotential VSS verbunden.

In einer Begrenzerschaltung B ist zwischen dem Ausgang OUT und der Leitung V5 für die 5 V Versorgung eine Diode D182 in Sperrichtung geschaltet und zwischen dem Ausgang OUT und Bezugspotential eine Diode D180 ebenfalls in Sperrichtung geschaltet.

Darüber hinaus liegt eine Lastkapazität C178 zwischen dem Ausgang und Bezugspotential beziehungsweise einer internen Masse und zwischen dem Ausgang und einer externen Masse V, die über Bonddrähte mit der internen Masse verbunden ist, liegt eine weitere Lastkapazität C179.

Liegt eine logische Eins am Sperreingang D, so ist das Ausgangssignal KP logisch Eins und das Ausgangssignal KN logisch Null, wodurch die Schalttransistoren M113 und M112 gesperrt und der Ausgang OUT im hochohmigen Zustand (Tristate) ist.

Mit einer logischen Null am Sperreingang D arbeitet die gesamte Treiberschaltung als Inverter, das heißt am Ausgang OUT liegt ein zum Signal am Eingang IN inverses Signal an.

Der Transistor M111 verhindert, daß die Drainspannung am Transistor M112 also am Knoten 1, zu groß wird, wenn sich die Schaltung im hochohmigen Zustand befindet und von außen eine hohe Spannung bis zu 5,7 V am Ausgang OUT auftritt. Solange der Knoten 1 auf niedrigem Potential liegt, leitet der Transistor M111, übersteigt das Potential am Knoten 1 eine Spannung von 3,3 V minus der Schwellenspannung des Transistors M111, so wird der Kanal des Transistors M111 abgeschnürt und verhindert auf diese Weise einen weiteren Potentialanstieg.

Im hochohmigen Zustand und bei Spannungen größer als 3,3 V am Ausgang OUT verhindert der Transistor M110, daß ein Strom in die Schaltung hineinfließt. In diesem Fall liegt das Gate über den Transistor M148 sowie der Knoten 2, der in diesem Fall den Sourceanschluß des Transistors M110 bildet, auf 3,3 V. Die Gate-Source-Spannung ist demnach Null und der Transistor M110 sperrt. Für den Fall, daß am Ausgang eine logische Eins anliegt, ist das Signal KP logisch Null und die beiden aus PMOS-Dioden geschalteten Transistoren M159 und M160 bewirken, daß der Knoten 5 auf etwa 3,3 V liegt. Dadurch liefert der aus den beiden Transistoren M148 und M154 gebildete Inverter eine Spannung von ca. 5 V am Knoten 3, also am Gate des Transistors M110. Der Transistor M154 ist dabei vorteilhafterweise sehr klein ausgelegt, damit das Potential am Knoten 3 nur langsam ansteigt. Durch die große Gate-Source-Kapazität des Transistors M110 wird das Potential am Knoten 3 und am Ausgang OUT also parallel angehoben und die Gatespannung des Transistors M110 bleibt auf diese Weise unterhalb des kritischen Wertes.

Für den Fall, daß am Ausgang ein Kurzschluß gegen Bezugspotential VSS auftritt, wird durch die Basis-Emitter-Diode des Bipolartransistors Q175 und durch den als PMOS-Diode geschalteten Transistor M166, die beide leitend werden, verhindert, daß die Spannung am Knoten 3 zu groß wird. Statt der Bipolar-Diode des Transistors Q175 kann auch eine weitere PMOS-Diode verwendet werden, was jedoch den Nachteil hat, daß das Gate des Transistors der weiteren PMOS-Diode am Ausgang liegt und daher besondere ESD-Schutzmaßnahmen erforderlich sind. Beim Einsatz einer NMOS-Diode tritt dieses Problem hingegen nicht auf, da das Gate in diesem Fall am Knoten 4 liegt. Problematisch ist dabei aber eine zu hohe Gate-Bulk-Spannung, wenn der Ausgang im hochohmigen Zustand von einem anderen Busteilnehmer mit 5 V beaufschlagt wird. In diesem Fall ist die NMOS-Diode nicht leitend und die Bulk-Spannung greift fast vollständig bis unter das Gateoxid durch, da sich kein Kanal unter dem Gate bildet.

Der Widerstand R176 dient als Strombegrenzung und schirmt den p-Kanal-MOS-Transistor M166 gegenüber dem Ausgang OUT ab, so daß eine minimale ESD-Schutzstruktur (ESD= Elektrostatic Discharge ) gegen die im 5 V Betriebsspannung ausreicht.

Bei den Transistoren M110 und M160 können zwar auch Gate-Bulk-Spannungen von ± 5 V auftreten. Da diese Transistoren in den entsprechenden Fällen aber immer leiten, teilt sich die Spannung, wegen dem Kanal unter dem Gate, auf die Raumladungszone und das Gateoxid auf. Die effektiv am Gateoxid anliegende Spannung ist demnach immer kleiner als die äußere Gate-Bulk-Spannung.

Beim PCI-Bus können durch Reflexionen am nicht abgeschlossenen Ende der Leitung Spannungen bis + 11 V und bis - 5 V auftreten. Diese Spannungen werden mit den Dioden D182 und D180 der Begrenzerschaltung auf Werte zwischen -0,7 V bis + 5,7 V begrenzt.

Die Schutzschaltung S sorgt dafür, daß zwischen Gate und Source des Transistors M110 nicht unerlaubterweise 5V anliegen, wenn der Ausgang OUT kurzgeschlossen wird und dabei das Gate von M110 durch die Ansteuerschaltung A auf High-Potential liegt.

In Figur 2 ist beispielhaft eine vorteilhafte Schaltung für die Ansteuerlogik AL gezeigt, die sechs p-Kanal-MOS-Transistoren M0, M11, M1, M2, M108 und M116 sowie sechs n-Kanal-MOS-Transistoren M17, M12, M13, M18, M109 und M114 aufweist. Ein erster Anschluß des Transistors M0 ist mit der Leitung V3, ein zweiter Anschluß des Transistors M0 über einen Knoten K4 mit einem ersten Anschluß des Transistors M11 und der Gateanschluß des Transistors M0 mit dem Eingang IN verbunden. Ein zweiter Anschluß des Transistors M11 ist über einen Knoten K1 mit einem ersten Anschluß des Transistors M17 verbunden, dessen Gate ebenfalls mit dem Eingang IN und dessen zweiter Anschluß mit Bezugspotential verbunden ist. Der Sperranschluß D ist mit dem Gate des Transistors M11 verbunden. Ein erster Anschluß des Transistors M1 ist mit der Leitung V3 und ein zweiter Anschluß des Transistors M1 über einen Knoten K3 mit einem ersten Anschluß des Transistors M12 verbunden, dessen zweiter Anschluß mit Bezugspotential verbunden ist und dessen Gate gemeinsam mit dem Gate des Transistors M1 mit dem Sperranschluß D verbunden ist. Ein erster Anschluß des Transistors M2 ist mit der Leitung V3 und ein zweiter Anschluß über den Knoten K4 mit einem ersten Anschluß des Transistors M13 verbunden, dessen zweiter Anschluß über den Transistors M18 mit Bezugspotential verbunden ist. Die Gateanschlüsse der Transistoren M2 und M13 sind über den Knoten K3 und der Gateanschluß des Transistors M18 ist mit dem Sperranschluß D verbunden. Ein erster Anschluß des Transistors M108 ist mit der Leitung V3 und ein zweiter Anschluß über den Knoten für das Signal KN mit einem ersten Anschluß des Transistors M109 verbunden, dessen zweiter Anschluß mit Bezugspotential und dessen Gateanschluß gemeinsam mit dem Gateanschluß des Transistors M108 mit dem Knoten K4 verbunden ist. Ein erster Anschluß des Transistors M116 ist mit der Versorgungsleitung V3 und ein zweiter Anschluß des Transistors M116 über einen Knoten für das Signal KP mit einem ersten Anschluß des Transistors M114 verbunden, dessen zweiter Anschluß mit Bezugspotential verbunden ist und dessen Gateanschluß gemeinsam mit dem Gateanschluß des Transistors M116 mit dem Knoten K1 verbunden ist.

## Patentansprüche

1. Treiberschaltung mit einer Ansteuerlogik (AL), einer Ansteuerschaltung (A), einem p-Kanal-MOS-Transistor (M113), einem ersten n-Kanal-MOS-Transistor (M110) vom Anreicherungstyp, einem zweiten n-Kanal-MOS-Transistor (M111) und einem dritten n-Kanal-MOS-Transistor (M112),
- bei der die Ansteuerlogik (AL) mit einer ersten Versorgungsspannung (V3) und Bezugspotential (VSS) versorgt ist, einen Sperreingang (D) und einen Signaleingang (IN) aufweist, der gleichzeitig den Eingang der Treiberschaltung darstellt,
- bei der die Ansteuerlogik (AL) einen Ausgang für ein erstes Ansteuersignal (KP) und einen Ausgang für ein dazu inverses zweites Ansteuersignal (KN) aufweist, wobei der Gateanschluß des p-Kanal-MOS-Transistors (M113) mit dem ersten Ansteuersignal und das Gate des dritten n-Kanal-MOS-Transistor (M112) mit dem zweiten Ansteuersignal beaufschlagt ist,
- bei der das erste Ansteuersignal (KP) der Ansteuerlogik über zwei in Reihe geschaltete Dioden (M159, M160) und über einen dazu in Reihe geschalteten Stromquellentransistor (M153) mit einer zweiten Versorgungsspannung (V5) verbunden ist, wobei die zweite Versorgungsspannung höher als die erste Versorgungsspannung ist, wobei ein Verbindungsknoten (5) zwischen einer der beiden Dioden und dem Stromquellentransistor mit dem Eingang eines CMOS-Inverters (M154, M148), der als Versorgungsspannungen die erste und die zweite Versorgungsspannung erhält und das Ausgangssignal der Ansteuerschaltung liefert, und wobei ein Gateanschluß des Stromquellentransistors (M153) mit der ersten Versorgungsspannung (V3) beschaltet ist,
- bei der ein Ausgang (3) der Ansteuerschaltung (A) mit dem Gate des ersten n-Kanal-MOS-Transistors (M110) verbunden ist und der Gateanschluß des zweiten n-Kanal-MOS-Transistors (M111) mit der ersten Versorgungsspannung (V3) beschaltet ist,
- bei dem ein erster Anschluß des p-Kanal-MOS-Transistors (M113) mit der ersten Versorgungsspannung (V3) und ein zweiter Anschluß dieses Transistors mit einem ersten Anschluß des ersten n-Kanal-MOS-Transistors (M110) verbunden ist, dessen zweiter Anschluß mit dem Ausgang (OUT) der Treiberschaltung verbunden ist, und
- bei der ein erster Anschluß des zweiten n-Kanal-MOS-Transistors (M111) mit dem Ausgang (OUT) der Treiberschaltung und ein zweiter Anschluß dieses Transistors mit einem ersten Anschluß des dritten n-Kanal-MOS-Transistors (M112) verbunden ist, dessen zweiter Anschluß mit Bezugspotential (VSS) verbunden ist.

2. Treiberschaltung nach Anspruch 1,
- bei der eine Schutzschaltung (S) derart vorgesehen ist, daß der Gateanschluß des ersten n-Kanal-MOS-Transistors (M110) über eine Diode (M116) mit dem Emitter eines Bipolartransistors (Q175) verbunden ist, dessen Basis über einen Widerstand (R176) mit dem Ausgang (OUT) der Treiberschaltung und dessen Kollektor direkt mit Bezugspotential (VSS) verbunden ist.

3. Treiberschaltung nach Anspruch 1 oder 2,
- bei der zwischen der zweiten Versorgungsspannung (V5) und dem Ausgang (OUT) der Vorrichtung eine in Sperrichtung gepolte Diode (D182) und zwischen dem Ausgang der Vorrichtung und Bezugspotential (VSS) eine weitere in Sperrichtung gepolte Diode (D180) vorgesehen sind.

## Claims

1. Driver circuit with a drive logic unit (AL), a drive circuit (A), a p-channel MOS transistor (M113), a first enhancement-mode n-channel MOS transistor (M110), a second n-channel MOS transistor (M111) and a third n-channel MOS transistor (M112),
- in which the drive logic unit (AL) is supplied with a first supply voltage (V3) and reference-earth potential (VSS), and has a disable input (D) and a signal input (IN), which simultaneously constitutes the input of the driver circuit,
- in which the drive logic unit (AL) has an output for a first drive signal (KP) and an output for a second drive signal (KN), which is the inverse of the said first drive signal, the first drive signal being applied to the gate terminal of the p-channel MOS transistor (M113) and the second drive signal being applied to the gate of the third n-channel MOS transistor (M112),
- in which the first drive signal (KP) of the drive logic unit is connected to a second supply voltage (V5) via two series-connected diodes (M159, M160) and via a current source transistor (M153) connected in series therewith, the second supply voltage being higher than the first supply voltage, a connecting node (5) between one of the two diodes and the current source transistor being connected up to the input of a CMOS inverter (M154, M148), which receives the first and the second supply voltage as supply voltages and supplies the output signal of the drive circuit, and a gate terminal of the current source transistor (M153) being connected up to the first supply voltage (V3),
- in which an output (3) of the drive circuit (A) is connected to the gate of the first n-channel MOS transistor (M110) and the gate terminal of the second n-channel MOS transistor (M111) is connected up to the first supply voltage (V3),
- in which a first terminal of the p-channel MOS transistor (M113) is connected to the first supply voltage (V3) and a second terminal of this transistor is connected to a first terminal of the first n-channel MOS transistor (M110), the second terminal of which is connected to the output (OUT) of the driver circuit, and
- in which a first terminal of the second n-channel MOS transistor (M111) is connected to the output (OUT) of the driver circuit and a second terminal of this transistor is connected to a first terminal of the third n-channel MOS transistor (M112), the second terminal of which is connected to the reference-earth potential (VSS).

2. Driver circuit according to Claim 1,
- in which a protective circuit (S) is provided in such a way that the gate terminal of the first n-channel MOS transistor (M110) is connected via a diode (M116) to the emitter of a bipolar transistor (Q175), whose base is connected to the output (OUT) of the driver circuit via a resistor (R176) and whose collector is connected directly to reference-earth potential (VSS).

3. Driver circuit according to Claim 1 or 2,
- in which a reverse-biased diode (D182) is provided between the second supply voltage (V5) and the output (OUT) of the apparatus, and a further reverse-biased diode (D180) is provided between the output of the apparatus and reference-earth potential (VSS).

## Revendications

1. Circuit d'attaque avec une logique d'excitation (AL), un circuit d'excitation (A), un transistor MOS à canal p (M113), un premier transistor MOS à canal n (M110) du type à enrichissement, un deuxième transistor MOS à canal n (M111) et un troisième transistor MOS à canal n (M112),
- dans lequel la logique d'excitation (AL) est alimentée par une première tension d'alimentation (V3) et un potentiel de référence (VSS), comporte une entrée de blocage (D) et une entrée de signal (IN), qui représente, en même temps, l'entrée du circuit d'attaque,
- dans lequel la logique d'excitation (AL) comporte une sortie pour un premier signal d'excitation (KP) et une sortie pour un deuxième signal d'excitation (KN), qui lui est inverse, le premier signal d'excitation étant appliqué à la borne de grille du transistor MOS à canal p (M113) et le deuxième signal d'excitation étant appliqué à la grille du troisième transistor MOS à canal n (M112),
- dans lequel le premier signal d'excitation (KP) de la logique d'excitation est relié, par l'intermédiaire de deux diodes (M159, M160), branchées en série, et d'un transistor (M153) de source de courant, qui y est raccordé en série, à une deuxième tension d'alimentation (V5), la deuxième tension d'alimentation étant plus élevée que la première tension d'alimentation, un noeud de raccordement (5) étant raccordé, entre une des deux diodes et le transistor de source de courant, à l'entrée d'un inverseur CMOS (M154, M148), lequel reçoit, en tant que tensions d'alimentation, la première et la deuxième tension d'alimentation et délivre le signal de sortie du circuit d'excitation, et une borne de grille du transistor (M153) de source de courant étant raccordée à la première tension d'alimentation (V3),
- dans lequel une sortie (3) du circuit d'excitation (A) est reliée à la grille du premier transistor MOS à canal n (M110) et la borne de grille du deuxième transistor MOS à canal n (M111) est connectée sur la première tension d'alimentation (V3),
- dans lequel une première borne du transistor MOS à canal p (M113) est reliée à la première tension d'alimentation (V3) et une deuxième borne de ce transistor à une première borne du premier transistor MOS à canal n (M110), dont la deuxième borne est reliée à la sortie (OUT) du circuit d'attaque, et
- dans lequel une première borne du deuxième transistor MOS à canal n (M111) est reliée à la sortie (OUT) du circuit d'attaque et une deuxième borne de ce transistor à une première borne du troisième transistor MOS à canal n (M112), dont la deuxième borne est reliée au potentiel de référence (VSS).

2. Circuit d'attaque selon la revendication 1
- dans lequel est prévu un circuit de protection (S) de telle sorte que la borne de grille du premier transistor MOS à canal n (M110) est reliée, par l'intermédiaire d'une diode (M116), à l'émetteur d'un transistor bipolaire (Q175), dont la base est reliée, par l'intermédiaire d'une résistance (R176), à la sortie (OUT) du circuit d'attaque et dont le collecteur est directement relié au potentiel de référence (VSS).

3. Circuit d'attaque selon la revendication 1 ou 2
- dans lequel, entre la deuxième tension d'alimentation (V5) et la sortie (OUT) du dispositif, est prévue une diode (D182) polarisée dans le sens de blocage et, entre la sortie du dispositif et le potentiel de référence (VSS), une autre diode (D180) polarisée dans le sens de blocage.
